# EUROPÄISCHE PATENTANMELDUNG

(11) **EP 1 113 337 A2**
(43) Veröffentlichungstag der Anmeldung: **04.07.2001**
(21) Anmeldenummer: 00124721.2
(22) Anmeldetag: 13.11.2000
(51) Int. Cl.: G03F 7/20

(54) **Optische Anordnung**

(30) Priorität: 29.12.1999 DE 19963587
(71) Anmelder: Carl Zeiss, 89518 Heidenheim (Brenz) (DE); Carl-Zeiss-Stiftung, trading as Carl Zeiss, 89518 Heidenheim (Brenz) (DE)
(72) Erfinder: Schuster, Karl-Heinz, 89551 Königsbronn (DE); Xalter, Stefan, 73447 Oberkochen (DE); Becker, Jochen, 73447 Oberkochen (DE); Von Bünau, Rudolf, 73457 Essingen (DE); Wagner, Christian, 73430 Aalen (DE); Hummel, Wolfgang, 73525 Schwäbisch Gmünd (DE); Holderer, Hubert, 89551 Königsbronn (DE)
(74) Vertreter: Ostertag, Ulrich, Dr.

(57) **Zusammenfassung**

Eine optische Anordnung, insbesondere eine Projektions-Belichtungsanlage der Mikrolithographie, weist insbesondere ein schlitzförmiges Bildfeld oder eine nicht rotationssymmetrische Beleuchtung auf. Dadurch wird ein optisches Element (5) von der Strahlung einer Lichtquelle nicht rotationssymmetrisch beaufschlagt. Zur Temperierung des optischen Elements (5) dient eine Zuführvorrichtung (11, 19 bis 23) für Gas. Diese umfaßt mindestens eine Zuführleitung (21) und mindestens eine Gas-Leiteinrichtung (11) . Letztere ist bezüglich des optischen Elements (5) so ausgerichtet und steuerbar, daß das Gas von der Gas-Leiteinrichtung (11) in Richtung auf das optische Element (5) geleitet wird. Der Volumenstrom des austretenden Gases weist dadurch eine Größe und räumliche Verteilung (17) auf, die an die Intensitätsverteilung (6) der Strahlung (1) angepaßt sind. Durch eine derartige Temperierung werden nicht rotationssymmetrische lichtinduzierte Abbildungsfehler im optischen Element (5) vermieden oder kompensiert.

## Beschreibung

Die Erfindung betrifft eine optische Anordnung, insbesondere eine Projektions-Belichtungsanlage der Mikrolithographie, insbesondere mit schlitzförmigem Bildfeld oder nicht rotationssymmetrischer Beleuchtung, mit einer Lichtquelle, die Strahlung emittiert, und einem optischen Element, das durch Beaufschlagung mit der Strahlung erwärmt wird, und einer Zuführvorrichtung für Gas zur Temperierung des optischen Elements.

Die Abbildungsqualität einer derartigen optischen Anordnung wird oftmals durch nicht rotationssymmetrische Abbildungsfehler gemindert. Derartige Abbildungsfehler entstehen z.B. außer durch nicht rotationssymmetrische lichtinduzierte Erwärmung des optischen Elements auch durch andere lichtinduzierte Effekt, wie z.B. "compaction", die eine entsprechende nicht rotationssymmetrische Ausdehnung bzw. Brechungsindexverteilung im optischen Element zur Folge haben. Bei hohen Anforderungen an die Abbildungsqualität, wie sie insbesondere bei Projektions-Belichtungsverfahren in der Mikrolithographie gefordert sind, können die beschriebenen lichtinduzierten Abbildungsfehler nicht toleriert werden und müssen daher entweder vermieden oder korrigiert werden.

Aus der US 5 920 377 A ist eine optische Anordnung der eingangs genannten Art bekannt, bei der die Temperaturverteilung in einem optischen System durch eine Gaszufuhr beeinflußt wird. Hierzu wird dem Volumenstrom eine räumliche Verteilung gegeben, die an die Intensitätsverteilung der Strahlung angepaßt ist. Das Gehäuse für das optische System ist dazu in mehrere Gas-Strömungsbereiche mit jeweils eigener Gaszuführung unterteilt. Die Vorgabe der räumlichen Verteilung des Volumenstroms erfolgt in der US 5 920 377 A durch die Gestaltung der Gas-Strömbereiche. Da die so beeinflußbare thermische Ankopplung der optischen Elemente des optischen Systems an die verschiedenen Gasströme über deren Umfangsfläche erfolgt, ist eine präzise Einstellung einer bestimmten Temperaturverteilung zum Ausgleich von Abbildungsfehlern nur sehr eingeschränkt möglich. Zusätzlich ist die Kontrolle der Strömungsverhältnisse in den Gas-Strömbereichen problematisch. Es ist nicht auszuschließen, daß sich in den Gas-Strömbereichen Totvolumina ausbilden, in denen das Gas im wesentlichen steht und daher unerwünscht kein Wärmetransport erfolgt.

Es ist daher die Aufgabe der vorliegenden Erfindung, eine optische Anordnung der eingangs genannten Art derart weiterzubilden, daß eine bessere Einstellung einer bestimmten Temperaturverteilung im optischen Element erreicht werden kann.

Diese Aufgabe wird erfindungsgemäß dadurch gelöst, daß die Zuführvorrichtung mindestens eine Zuführleitung und mindestens eine Gas-Leiteinrichtung umfaßt, die so bezüglich des optischen Elements ausgerichtet und steuerbar ist, daß das Gas von der Gas-Leiteinrichtung als freie Strömung in Richtung auf das optische Element geleitet wird und der Volumenstrom des austretenden Gases eine Größe und räumliche Verteilung aufweist, die an die Intensitätsverteilung der Strahlung angepaßt sind.

Mittels einer derartigen Gas-Leiteinrichtung kann die Temperierung des dem Gas ausgesetzten Bereichs des optischen Elements gut an die Form des lichtinduzierten Abbildungsfehlers angepaßt und die Temperaturverteilung im optischen Element gezielt vorgegeben werden. Durch die Gas-Leiteinrichtung erfolgt hierbei ein direktes Anströmen des optischen Elements, so daß über die thermische Ankopplung von letzterem an den Gasstrom eine effektive Temperierung gegeben ist. Totvolumina, aus denen Gas nicht abgeführt wird, werden insbesondere in den zu temperierenden Bereichen des optischen Elements vermieden.

Durch Wärmeankopplung an das vorbeiströmende Gas erfolgt hierbei z.B. eine weitgehende Kompensation der asymmetrischen Erwärmung durch die Lichtabsorption, sodaß eine rotationssymmetrische Temperaturverteilung resultiert. Abbildungsfehler, die auf einer Wärmeausdehnung des Materials des optischen Elements beruhen, werden auf diese Weise vermieden. Durch eine gezielte Anströmung des optischen Elements ist aber auch eine Kompensation zusätzlicher Abbildungsfehler möglich, die z.B. durch compaction und die daraus resultierende Brechungsindexänderung verursacht werden. Dazu wird mittels der Gasanströmung gezielt eine asymmetrische Temperaturverteilung im optischen Element herbeigeführt, wobei sich die dadurch ergebenden Änderungen der Abbildungseigenschaften des optischen Elements durch die asymmetrische Ausdehnung des Materials des optischen Elements und die z.B. durch compaction hervorgerufenen Abbildungsfehler so kompensieren, daß insgesamt vorgegebene Abbildungseigenschaften des optischen Elements resultieren.

In mindestens einer Zuführleitung für die Gas-Leiteinrichtung kann ein Drosselventil angeordnet sein. Dadurch läßt sich auf einfache Weise die Größe des Volumenstroms an die Erfordernisse für die Temperierung des optischen Elements anpassen.

Die Gas-Leiteinrichtung kann durch mindestens eine Düse gebildet sein, die über die Zuführleitung mit einer Gasquelle verbunden ist. Mittels einer Düse ist ein präzises Anströmen eines zu temperierenden Bereichs des optischen Elements möglich.

Bevorzugt sind mehrere Gas-Leiteinrichtungen vorgesehen, denen je ein Drosselventil in einem Zuführ-Leitungsabschnitt zugeordnet ist. Dadurch ist eine Anpassung an eine Lichtbeaufschlagung mit Projektionslicht möglich, deren Intensitätsverteilung über die Beaufschlagungsfläche des optischen Elements variiert. Bereiche, die einer erhöhten lichtinduzierten Erwärmung ausgesetzt sind, können beispielsweise bei Verwendung eines Kühlgases entsprechend stärker angeströmt werden.

Für die Gas-Leiteinrichtung kann eine justierbare Halteeinrichtung vorgesehen sein. Dies ermöglicht ein gezieltes Ausrichten der Gas-Leiteinrichtung gegenüber dem optischen Element.

Die Halteeinrichtung kann eine Justiereinrichtung zur Einstellung der Axialposition der Gas-Leiteinrichtung gegenüber dem optischen Element aufweisen. Dadurch ist eine Größeneinstellung des Anströmbereichs des aus der Gas-Leiteinrichtung in Richtung des optischen Elements strömenden Gasstroms möglich.

Alternativ oder zusätzlich kann die Halteeinrichtung eine Justiereinrichtung zur Einstellung der Neigung der Gas-Leiteinrichtung gegenüber dem optischen Element aufweisen. Mittels einer Neigungseinstellung ist sowohl die Position als auch die Form des jeweiligen Anströmbereichs einer Gas-Leiteinrichtung gegenüber dem optischen Element einstellbar.

Bevorzugt ist eine mit dem mindestens einen Drosselventil in Signalverbindung stehende Steuereinrichtung zur Vorgabe eines Gas-Volumenstroms in der Gas-Leiteinrichtung vorgesehen. Dies ermöglicht eine automatische und präzise Einstellung des Volumenstroms des zur Temperierung vorgesehenen Gases.

Dabei kann die Steuereinrichtung mit der Lichtquelle zum Empfang eines der Lichtleistung der Lichtquelle entsprechenden Signals in Signalverbindung stehen, wobei die Vorgabe des Gas-Volumenstroms durch die Steuereinrichtung abhängig vom übermittelten Signal der Lichtquelle erfolgt. Dies ermöglicht eine Anpassung der Gastemperierung an die jeweils eingesetzte Projektionslichtleistung.

Alternativ oder zusätzlich ist eine mit der Steuereinrichtung in Signalverbindung stehende Sensoranordnung zur Überwachung der Abbildungsqualität des optischen Elements und/oder der optischen Anordnung vorgesehen, wobei die Vorgabe des Gas-Volumenstroms durch die Steuereinrichtung abhängig von den übermittelten Signaldaten der Sensoranordnung erfolgt. Dadurch ist eine Regelung der Gaszuführung möglich, bei der das optische Element in den Bereichen über die Gaszufuhr temperiert wird, die anhand der Signaldaten zur Abbildungsqualität von der Steuereinrichtung vorgegeben werden. Eine derartige Regelung erlaubt z.B. eine Abbildungskorrektur eines Systems optischer Elemente. Dabei werden mittels der Gastemperierung eines optischen Elements die Abbildungseigenschaften von diesem derart überkompensiert, daß trotz der lichtinduzierten Abbildungsfehler der anderen optischen Elemente insgesamt eine abbildungskorrigierte optische Anordnung resultiert.

Die Sensoranordnung kann ein CCD-Array aufweisen. Mittels einer derartigen Sensoranordnung ist eine präzise Erfassung der Abbildungseigenschaften des optischen Elements bzw. der optischen Anordnung möglich.

Bevorzugt ist die Gas-Leiteinrichtung Teil einer Spüleinrichtung für das optische Element und/oder die optische Anordnung. Die Funktionen Spülen und Temperieren werden auf diese Weise zusammengefaßt.

Bei einer bevorzugten Ausführungsform ist eine thermostatisierte Temperiereinrichtung in der Zuführleitung vorgesehen. Dies ermöglicht eine exakte Temperaturvorgabe des Gasstroms, so daß die mit einem Gasstrom mit vorgegebenem Volumenstrom mögliche Temperierung exakt bestimmbar ist.

Ein Ausführungsbeispiel der Erfindung wird nachfolgend anhand der Zeichnung näher erläutert; es zeigen:
- Figur 1:: einen Meridionalschnitt einer optischen Anordnung mit einer Gas-Temperiervorrichtung für eine Linse;
- Figur 2:: einen Schnitt gemäß Line II-II von Figur 1; und
- Figur 3:: in größerem Maßstab eine justierbare Düse der Gas-Temperiervorrichtung in einer Neutralstellung.

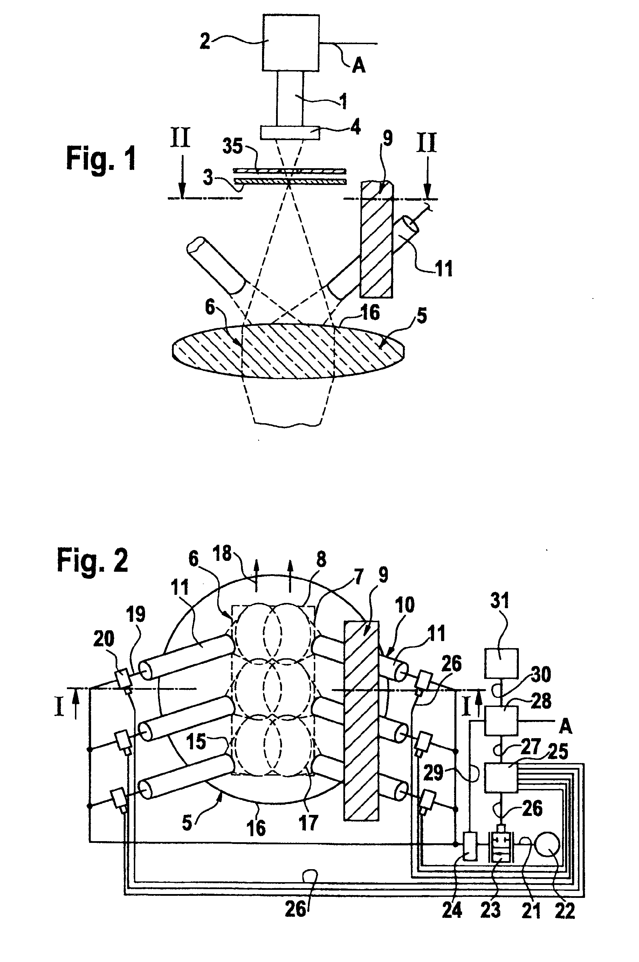

Die in Figur 1 schematisch dargestellte optische Anordnung ist Teil einer Projektions-Belichtungsanlage für die Mikrolithographie. Dabei wird ein Projektions-Lichtbündel 1 einer Lichtquelle 2 zur Abbildung eines Retikels 3, das die zu projizierende Strukturinformation trägt, auf einen in Figur 1 nicht dargestellten Wafer geführt. Als Lichtquelle 2 dient typischerweise ein leistungsstarker UV-Laser, beispielsweise ein Argon-Fluorid-Excimerlaser.

Optische Elemente zur Führung bzw. Formung des Projektions-Lichtbündels 1 sind eine Fokussieroptik 4, die das Projektions-Lichtbündel 1 auf das Retikel 3 fokussiert, eine Maske 35, die den Querschnitt des Projektions-Lichtbündels in noch zu beschreibender Weise zur Vorgabe eines schlitzförmigen Bildfelds begrenzt, und eine Linse 5, die Teil eines Projektionsobjektivs ist, mit dem die Strukturinformation des Retikels 3 auf den Wafer abgebildet wird. Die Linse 5 besteht aus für UV-Licht gut durchlässigem Material wie Quarzglas oder CaF₂.

Beim Durchdringen der Linse 5 hat das Projektions-Lichtbündel 1 eine von der Maske 35 vorgegebene rechteckige Querschnittsfläche, die in Figur 2 durch ein gestricheltes Rechteck 6 dargestellt ist. Die Querschnittsfläche 6 weist eine Längsseite 7 und eine Schmalseite 8 auf, deren Längenverhältnis ungefähr 3:1 ist.

Parallel zu den Längsseiten 7 der Querschnittsfläche 6 sind in Figur 1 bezüglich der Linse 5 nach oben und außen versetzt zwei Halteblöcke 9 für je eine Düsengruppe 10 angeordnet. Eine Düsengruppe 10 besteht aus drei Gasdüsen 11. Zur besseren Übersichtlichkeit ist in den Figuren 1 und 2 nur jeweils der rechte der beiden Halteblöcke 9 dargestellt.

Die Gasdüsen 11 sind als Gas-Leiteinrichtungen Teil einer Zuführvorrichtung für Gas, die nachfolgend beschrieben wird:

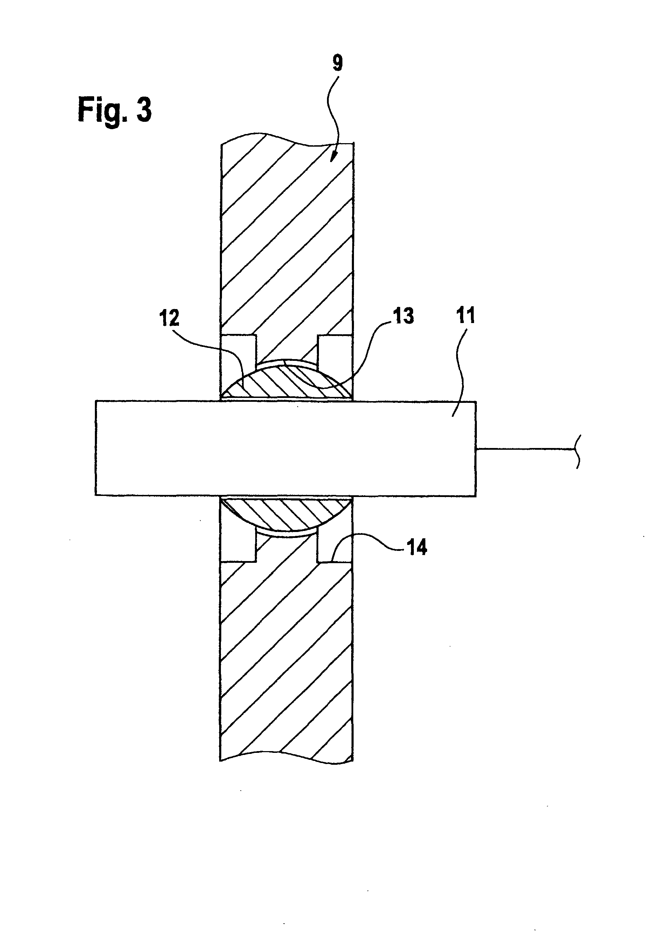

In Figur 3 ist gezeigt, daß die Gasdüse 11 in dem Halteblock 9 sowohl bezüglich ihrer Axialposition als auch bezüglich ihrer Neigung zur Linse 5 einstellbar ist. Zur Einstellung der Neigung dient eine Gelenkkugel 12. Diese ist in eine die Gasdüse 11 ringförmig umgebende Aufnahme 13 des Halteblocks 9 satt eingepaßt, die eine zur Gelenkkugel 12 komplementäre Kugelkalottenfläche vorgibt.

Im Bereich der Gelenkkugel 12 weist der Halteblock 9 der Aufnahme 13 benachbart stufenförmige Ringausnehmungen 14 auf. Diese ermöglichen eine Neigung der Gasdüse 11 relativ zu der in Figur 3 gezeigten Neutralstellung, in der die Gasdüse 11 senkrecht zur Ringebene der Aufnahme 13 steht, bis zu einem Winkel von ca. 60°. Die Gasdüse 11 wiederum ist satt von der Gelenkkugel 12 aufgenommen, so daß eine Einstellung der Axialposition der Gasdüse 11 durch einfaches axiales Verschieben in der Gelenkkugel 12 möglich ist.

Alternativ oder zusätzlich können die Halteblöcke 9 insgesamt justierbar ausgeführt sein, so daß durch Translation bzw. Rotation der Halteblöcke 9 eine Gesamtverstellung der jeweiligen Düsengruppe 10 möglich ist.

Aus den Gasdüsen 11 strömt jeweils ein Gasstrom 15, dessen in der Zeichnung übertrieben divergent dargestellte Randkontur in den Figuren 1 und 2 als gestrichelter Kegel angedeutet ist. Als in der Gas-Temperiervorrichtung einsetzbares Gas kommt z.B. ein Edelgas wie Helium in Frage. Alternativ kann auch getrocknete und gefilterte Druckluft verwendet werden.

Der Gasstrom 15 ist auf eine Linsenoberfläche 16 der Linse 5 gerichtet. Bedingt durch die Neigung der Gasdüsen 11 relativ zur angeströmten Linsenoberfläche 16 wird von jeder Gasdüse 11 auf der Linsenoberfläche 16 ein in etwa elliptischer Anströmbereich 17 mit Gas direkt beaufschlagt. Die Anströmbereiche 17 sind in Figur 2 als gestrichelte Ellipsen angedeutet.

Die Gesamtheit der Anströmbereiche 17 der sechs Gasdüsen 11 deckt die Querschnittfläche 6, mit der die Linse 5 vom Projektions-Lichtbündel 1 beaufschlagt wird, im wesentlichen ab. Bedingt durch die Neigung der Gasdüsen 11 zur in Figur 1 dargestellten Meridionalebene (vgl. Figur 2) haben die aus den Gasdüsen 11 strömenden Gasströme 15 nach dem Auftreffen auf die Linsenoberfläche 16 eine Vorzugsrichtung parallel zu dieser mit Geschwindigkeitskomponenten parallel und senkrecht zur Symmetrieebene der beiden Düsengruppen 10. In dieser Symmetrieebene heben sich die Geschwindigkeitskomponenten der Gasströme 15 parallel zur in Figur 1 dargestellten Meridionalebene auf. Es verbleibt eine resultierende Geschwindigkeitskomponente 18 senkrecht zur in Figur 1 dargestellten Meridionalebene.

Jeder Gasdüse 11 ist ein Zuführ-Leitungsabschnitt 19 für Gas zugeordnet, in dem jeweils ein steuerbares Drosselventil 20 angeordnet ist. Die Zuführ-Leitungsabschnitte 19 der einzelnen Gasdüsen 11 vereinigen sich zu einer Zuführleitung 21, die von einem Gas-Vorratsbehälter 22 gespeist wird. In der Zuführleitung 21 sind als Hauptventil 23 ein drosselndes 2/2-Wegeventil sowie eine thermostatisierte Temperiereinrichtung 24 für das Gas angeordnet.

Die Ansteuerung der Drosselventile 20 sowie des Hauptventils 23 erfolgt mittels einer Ventilsteuerschaltung 25, die über Signalleitungen 26 mit den Drosselventilen 20 bzw. dem Hauptventil 23 in Signalverbindung steht. Die Ventilsteuerschaltung 25 ist über eine weitere Signalleitung 27 mit einer Belichtungs-Steuerungschaltung 28 für die Projektions-Belichtungsanlage verbunden. Eine weitere Signalleitung 29 verbindet die Belichtungs-Steuerungsschaltung 28 mit der thermostatisierten Temperiereinrichtung 24. Über die Anschlußklemme A steht die Belichtungs-Steuerungsschaltung 28 mit der Lichtquelle 2 (vgl. Figur 1) in Verbindung. Eine weitere Signalleitung 30 verbindet die Belichtungs-Steuerungsschaltung 28 mit einem zweidimensionalen CCD-Array 31.

Die Gas-Temperiervorrichtung für die Linse 5 funktioniert folgendermaßen:

Die Linsen in der optischen Anordnung der Projektions-Belichtungsanlage, z.B. die Linse 5, erwärmen sich aufgrund der Restabsorption, die das Material, aus dem sie gefertigt sind, im Bereich der Wellenlänge des Projektion-Lichtbündels 1 aufweist. Diese Erwärmung, deren Temperaturverteilung in erster Näherung der absorbierten Strahlungsleistungsverteilung in den Linsen folgt, führt sowohl zu einer thermischen Ausdehnung des Materials als auch zu einer Brechungsindexänderung und daher, bedingt durch die geänderten Brechungseigenschaften, zu einer Änderung der Abbildungseigenschaften der Linsen. Ziel des Einsatzes der Gas-Temperiervorrichtung ist es, über die thermische Ankopplung des an der Linse 5 vorbeiströmenden Gases eine Homogenisierung bzw. eine gezielte Formung der Temperaturverteilung in der Linse 5 zu erreichen. Eine daraus resultierende homogenisierte bzw. vorgegebene thermische Ausdehnung führt zu vernachlässigbaren bzw. gut beherrschbaren Abbildungsfehlern.

Beim Einschalten der Projektions-Belichtungsanlage gibt die Belichtungs-Steuerungsschaltung 28 zunächst Rohwerte für die Gastemperatur sowie den Gas-Volumenstrom vor, die in einem Vorversuch als geeignet ermittelt wurden. Die Gastemperatur wird dabei so eingestellt, daß sie niedriger ist als die Betriebstemperatur der optischen Anordnung. Eine typische Temperaturdifferenz zwischen Gastemperatur und Betriebstemperatur ist hierbei 5°.

Die Einstellung der Gastemperatur erfolgt durch eine Soll-Wert-Vorgabe der Belichtungs-Steuerungsschaltung 28 über die Signalleitung 29 an die thermostatisierte Temperiereinrichtung 24. Die Gas-Volumenströme werden durch eine entsprechende Vorgabe der Öffnungsweiten für die Drosselventile 20 bzw. das Hauptventil 23 eingestellt, wobei diese Soll-Werte von der Belichtungs-Steuerungsschaltung 28 über die Signalleitung 27 an die Ventilsteuerschaltung 25 übermittelt werden. Diese nimmt, diesen Soll-Werten folgend, eine entsprechende Ansteuerung der Drosselventile 20 bzw. des Hauptventils 23 vor. Die Einstellung des Hauptventils 23 dient dabei einer Grundvorgabe des Gas-Volumenstroms, z.B. zur Vorgabe des maximal zulässigen durch die Gasdüsen 11 strömenden Gas-Volumenstroms. Mittels der Drosselventile 26 erfolgt abhängig von den vorgegebenen Soll-Werten eine entsprechende Reduzierung dieses maximalen Gas-Volumenstroms für diejenigen Gasdüsen 11, für die von der Belichtungs-Steuerungsschaltung 28 ein geringerer Gas-Volumenstrom vorgegeben ist.

Durch die Beaufschlagung der Linsenoberfläche 16 mit dem aus den Gasdüsen 11 strömenden Gas erfolgt über die thermische Ankopplung eine Wärmeabfuhr von der Linse 5 auf das Gas, was zu einem Abkühlen der Linse 5 in dem angeströmten Bereich führt.

Durch diese Abkühlung wird die Erwärmung, die durch Restabsorption des Projektions-Lichtbündels 1 in der Linse 5 erfolgt, kompensiert. Als Folge dieser Kompensation werden durch die Erwärmung bedingte Abbildungsfehler der Linse 5 bzw. der gesamten optischen Anordnung reduziert. Die Abbildungsqualität der optischen Anordnung wird über das CCD-Array 31 gemessen, das in nicht dargestellter Weise in einer Bildebene der Projektions-Belichtungsanlage liegt. Abhängig vom Meßergebnis des CCD-Arrays 31 und der daraus über bekannte Bildverarbeitungs-Algorithmen bestimmten Abbildungsqualität der optischen Anordnung werden in der Belichtungs-Steuerungsschaltung 28 optimierte Betriebsparameter der Gas-Temperiervorrichtung berechnet. Diese neuen Betriebsparameter, d.h. eine optimierte Gastemperatur sowie optimierte Öffnungsweiten für die Drosselventile 20 bzw. das Hauptventil 23, werden dann über die thermostatisierte Temperiereinrichtung 24 sowie die Ventilsteuerschaltung 25 eingestellt. Auf diese Weise wird iterativ ein Betriebszustand erreicht, bei dem die Abbildungsfehler der optischen Anordnung minimiert sind.

Zusätzlich zu den oben beschriebenen einstellbaren Betriebsparametern Gastemperatur sowie Gas-Volumenstrom kann auch die Positionierung der Gasdüsen 11 relativ zur Linse 5 automatisch einstellbar sein. Die in der Figur 3 beschriebene Anordnung zur Einstellung der Gasdüse 11 weist dann zusätzlich Aktuatoren (nicht dargestellt) zur Einstellung der Neigung und der Axialposition auf, wobei die Aktuatoren von der Belichtungs-Steuerungsschaltung 28 angesteuert werden.

Auf diese Weise kann über die Axialposition der Gasdüsen 11 die Größe des Anströmbereichs 17 eingestellt werden. Je weiter das Ende der Düse 11 von der Linsenoberfläche 16 entfernt ist, desto größer wird aufgrund der Divergenz des Gasstroms 15 der Anströmbereich 17. Über die Neigung der Gasdüse 11 zur Linsenoberfläche 16 läßt sich wiederum die Elliptizität des Anströmbereichs 17 einstellen. Zusätzlich sind über die Neigung der Gasdüsen 11 die Positionen der jeweiligen Anströmbereiche 17 relativ zur Querschnittsfläche 6 des Projektions-Emissionsbündels 1 einstellbar. Eine inhomogene Leistungsverteilung des Projektions-Lichtbündels 1 innerhalb der Querschnittsfläche 6 und eine daraus resultierende inhomogene lichtinduzierte Brechungsindexverteilung in der Linse 5 können auf diese Weise optimal kompensiert werden.

Mit der Gas-Temperiervorrichtung sind abhängig von der auf das CCD-Array 31 abgebildeten Bildebene sowohl eine optimale Kompensierung von Abbildungsfehlern der Linse 5 alleine als auch eine Kompensierung von Abbildungsfehlern der gesamten optischen Anordnung möglich. Im letzteren Falle wird durch entsprechendes Anströmen der Linse 5 und daraus resultierende Gaskühlung eine gezielte Überkompensation der Abbildungseigenschaften der Linse 5 eingestellt, so daß in Verbindung mit den Abbildungsfehlern der sonstigen optischen Elemente der optischen Anordnung insgesamt eine Verbesserung der Abbildungseigenschaften der optischen Anordnung resultiert.

Statt durch Gaskühlung ist durch eine analoge Gas-Erwärmungsvorrichtung auch eine Kompensation von Abbildungsfehlern über eine Gasheizung der Linse 5 möglich. Dabei muß die Gesamtheit der Anströmbereiche 17 eine derartige Fläche beaufschlagen, daß sich die beiden Erwärmungsbeiträge, d.h. einerseits die Erwärmung durch die Restabsorption des Projektions-Lichtbündels 1 und andererseits die Erwärmung durch den Gasstrom zu einer im wesentlichen homogenen Erwärmung ergänzen. Die bei einer solchen Gasheizung beaufschlagte Linsenoberfläche 16 ist in diesem Fall im wesentlichen komplementär zur in Fig. 2 dargestellten Querschnittsfläche 6 des Projektions-Lichtbündels 1.

Die Rohwerte für die einzustellende Gastemperatur bzw. den Gas-Volumenstrom werden von der momentanen Belichtungsleistung der Laserquelle 2 beeinflußt. Diese momentane Belichtungsleistung ruft die Belichtungs-Steuerungsschaltung 28 über die Ausgangsklemme A von der Lichtquelle 2 ab.

Mit dem Gas der Gas-Temperiervorrichtung ist zusätzlich auch ein Spülen der Linse 5 bzw. der gesamten optischen Anordnung möglich.

## Patentansprüche

1. Optische Anordnung, insbesondere Projektions-Belichtungsanlage der Mikrolithographie, insbesondere mit schlitzförmigem Bildfeld oder nicht rotationssymmetrischer Beleuchtung, mit einer Lichtquelle, die Strahlung emittiert, und einem optischen Element, das durch Beaufschlagung mit der Strahlung erwärmt wird, und einer Zuführvorrichtung für Gas zur Temperierung des optischen Elements,
dadurch gekennzeichnet, daß
die Zuführvorrichtung (11, 19 bis 23) mindestens eine Zuführleitung (21) und mindestens eine Gas-Leiteinrichtung (11) umfaßt, die so bezüglich des optischen Elements (5) ausgerichtet und steuerbar ist, daß das Gas von der Gas-Leiteinrichtung (11) als freie Strömung in Richtung auf das optische Element (5) geleitet wird und der Volumenstrom des austretenden Gases eine Größe und räumliche Verteilung (17) aufweist, die an die Intensitätsverteilung (6) der Strahlung (1) angepaßt sind.

2. Optische Anordnung nach Anspruch 1, dadurch gekennzeichnet, daß in mindestens einer Zuführleitung (21) für die Gas-Leiteinrichtung (11) ein Drosselventil (23) angeordnet ist.

3. Optische Anordnung nach Anspruch 1 oder 2, dadurch gekennzeichnet, daß die Gas-Leiteinrichtung durch mindestens eine Düse (11) gebildet ist, die über die Zuführleitung (21) mit einer Gasquelle (22) verbunden ist.

4. Optische Anordnung nach einem der vorhergehenden Ansprüche, dadurch gekennzeichnet, daß mehrere Gas-Leiteinrichtungen (11) vorgesehen sind, denen je ein Drosselventil (20) in einem Zuführ-Leitungsabschnitt (19) zugeordnet ist.

5. Optische Anordnung nach einem der vorhergehenden Ansprüche, dadurch gekennzeichnet, daß eine justierbare Halteeinrichtung (9) für die Gas-Leiteinrichtung (11) vorgesehen ist.

6. Optische Anordnung nach Anspruch 5, dadurch gekennzeichnet, daß die Halteeinrichtung (9) eine Justiereinrichtung (12) zur Einstellung der Axialposition der Gas-Leiteinrichtung (11) gegenüber dem optischen Element (5) aufweist.

7. Optische Anordnung nach Anspruch 5 oder 6, dadurch gekennzeichnet, daß die Halteeinrichtung (9) eine Justiereinrichtung (12) zur Einstellung der Neigung der Gas-Leiteinrichtung (11) gegenüber dem optischen Element (5) aufweist.

8. Optische Anordnung nach einem der Ansprüche 2 bis 8, gekennzeichnet durch eine mit dem mindestens einen Drosselventil (20, 23) in Signalverbindung (26) stehende Steuereinrichtung (25) zur Vorgabe eines Gas-Volumenstroms in der Gas-Leiteinrichtung (11).

9. Optische Anordnung nach Anspruch 8, dadurch gekennzeichnet, daß die Steuereinrichtung (25) mit der Lichtquelle (2) zum Empfang eines der Lichtleistung der Lichtquelle entsprechenden Signals in Signalverbindung (27, 28, A) steht, wobei die Vorgabe des Gas-Volumenstroms durch die Steuereinrichtung (25) abhängig vom übermittelten Signal der Lichtquelle (2) erfolgt.

10. Optische Anordnung nach Anspruch 8 oder 9, gekennzeichnet durch eine mit der Steuereinrichtung (25) in Signalverbindung (27, 28, 30) stehende Sensoranordnung (31) zur Überwachung der Abbildungsqualität des optischen Elements (5) und/oder der optischen Anordnung (4, 5), wobei die Vorgabe des Gas-Volumenstroms durch die Steuereinrichtung (25) abhängig von den übermittelten Signaldaten der Sensoranordnung (31) erfolgt.

11. Optische Anordnung nach Anspruch 10, dadurch gekennzeichnet, daß die Sensoranordnung ein CCD-Array (31) aufweist.

12. Optische Anordnung nach einem der vorhergehenden Ansprüche, dadurch gekennzeichnet, daß die Gas-Leiteinrichtung (11) Teil einer Spüleinrichtung für das optische Element (5) und/oder die optische Anordnung (4, 5) ist.

13. Optische Anordnung nach einem der vorhergehenden Ansprüche, gekennzeichnet durch eine thermostatisierte Temperiereinrichtung (24) in der Zuführleitung (21).
